# EUROPEAN PATENT SPECIFICATION

(11) **EP 3 671 806 B1**
(45) Date of publication and mention of the grant of the patent: **02.12.2020**
(21) Application number: 18214105.1
(22) Date of filing: 19.12.2018
(51) Int. Cl.: H01J 37/34, H01J 37/32, C23C 14/35

(54) **MAGNETRON SPUTTERING CATHODE ASSEMBLY FOR AN UNBALANCED MAGNETRON SPUTTERING APPARATUS**
MAGNETRON-SPUTTERKATHODENANORDNUNG FÜR EINE SPUTTERVORRICHTUNG MIT UNGLEICHMÄSSIGEM MAGNETRON
ENSEMBLE CATHODIQUE DE PULVÉRISATION PAR MAGNÉTRON POUR UN APPAREIL DE PULVÉRISATION PAR MAGNÉTRON DÉSÉQUILIBRÉ

(43) Date of publication of application: 24.06.2020
(73) Proprietor: Emea Inor Eood, 4000 Plovdiv (BG)
(72) Inventor: Waidelich, Romain, 70197 Stuttgart (DE)
(74) Representative: Hoeger, Stellrecht & Partner Patentanwälte mbB

(56) References cited:
- RU-C2- 2 319 788
- RU-U1- 111 138
- US-A- 4 517 070
- US-A1- 2003 161 969

## Description

### FIELD OF THE INVENTION

The invention relates to a magnetron sputtering cathode assembly, an unbalanced magnetron sputtering apparatus comprising such an assembly, and its use for surface treatment or coating of products.

The purpose of deposition of functional coatings in vacuum is to obtain the required physical and chemical properties of the films, such as electrical, optical, magnetic, mechanical, anticorrosive and catalytic properties, or a combination thereof: for example, indium-tin oxide thin films possess both optical transparency and electrical conductivity. As functional coatings, metal films in the form of alloys and their compounds with oxygen, nitrogen, and carbon (so-called reactive coatings) are most often used.

Functional coatings of complex chemical composition can be obtained using the technique of ion sputtering in a vacuum, such as cathode sputtering and its industrial modification - magnetron sputtering.

The quality of coatings applied by magnetron sputtering is significantly higher than the quality of coatings applied by traditional techniques of electroplating or arc evaporation in vacuum. Magnetron sputtering apparatuses are characterized by significant increase of the "ionic impact" degree during the coating growth, as well as by an ability to control that "assisting" ion bombardment of the coating. These magnetron sputtering apparatuses are called unbalanced magnetrons (UBM) or magnetrons with a double site sustained discharge (DSSD) *(see "*Magnetic field and substrate position effects on the ion/deposition flux ratio in magnetron sputtering" - G.A. Clarke, N.R. Osborne, and R.R. Parsons, - J. Vac. Sci. Technol. A 9(3), May/Jun 1991, pp.1166-1172*).*

Due to a special configuration of the UBM magnetic field, the surface of the growing film is bombarded with an intense flux of plasma ions at large distances from the magnetron sputtering apparatus to the substrate. A feature of the UBM is the presence of an additional magnetic field in the form of a "bottle" of a sufficient strength to capture electrons with an energy exceeding the ionization energy of the plasma-forming gas and of the sputtered material. According to calculations and experimental data, the magnitude of the magnetic field strength should be not less than 100 Oe *(see "*Magnetic field and substrate position effects on the ion/deposition flux ratio in magnetron sputtering" - G.A. Clarke, N.R. Osborne, and R.R. Parsons, - J. Vac. Sci. Technol. A 9(3), May/Jun 1991, pp.1166-1172*.)*

To achieve these requirements, all magnets in a permanent magnet magnetron sputtering apparatus are located on the periphery of the device along the perimeter of the target. It is allowed to place a shunt made of material with a high magnetic permeability in the centre of the magnetron sputtering apparatus.

Ion bombardment of the growing film surface enables to control the nucleation characteristics, morphology, chemical composition, microstructure and stress in the film. This is due to an increase in the mobility of adsorbed atoms, re-sputtering of weakly bound particles, as well as to the high energy of bombarding ions of the plasma-forming gas and target material. The coatings applied by unbalanced magnetron (UBM) sputtering have a complex of extraordinary mechanical, thermal and optical properties (high hardness, wear resistance, electrical conductivity, thermal conductivity, optical density). Such coatings radically differ from coatings obtained by the electroplating technique and from coatings deposited by vacuum arc evaporation, which are characterized by porosity and droplet phase, respectively.

Unbalanced magnetrons allow to apply coatings by reactive sputtering at low (up to 373 K) temperature on workpieces made of low temperature resistance materials. Compared to conventional magnetron sputtering apparatuses, UBM has a special configuration and magnitude of the magnetic field, that provides an additional ionization zone for the sputtered atoms as well as for the working gas atoms above the target surface. When a bias voltage is applied to the substrate, the density of the substrate ion bias current practically does not change when the target-to-substrate distance varies from 40 to 200 mm. For conventional magnetrons, the target-to-substrate distance at which the substrate ion current density does not change is about three times shorter.

Thus, compared to a conventional magnetron sputtering apparatus, UBM allows to increase maximum target-to-substrate distances from 50 mm for conventional magnetrons up to 100-200 mm for UBMs, wherein it is still possible to obtain high-quality reactive coatings. This allows to increase the capacity of industrial plants by increasing the "effective" coating area, as well as to apply coatings on large and complex shape parts.

When a high bias voltage is applied to the workpiece (Uₛ = 700-1200 V), the substrate ion current Iₛ obtained from the DSSD can be higher than the magnetron discharge current I_{d}:
Iₛ = N x I_{d}, where the N coefficient can reach 3-5, depending on the bias voltage.

In such a case, the coating deposition rate is much lower than the etch removal rate. Therefore, UBM is suitable for final cleaning and heating of workpieces before coating.

Analysis of scientific, technical and patent literature shows a current tendency, on the one hand, to increase the substrate dimensions and, on the other hand, to simplify the UBM design in order to combine several functions, such as cleaning and etching of the substrate, application of coating, uniform or predetermined gas distribution, protection of the workpieces surface from contamination in the course of cleaning and preheating of sputter targets.

UBMs located inside the vacuum chamber and operating under increased thermal loads, are in demand.

In addition, complex shaped substrates, such as telescope mirrors, vehicle glazing, ball valves, besides large dimensions, have a curvilinear surface, which requires a curved shape of magnetron sputter targets to achieve high uniformity of coating thickness.

### BACKGROUND ART

From RU 2 319 788 C2, a cathode assembly of a magnetron sputtering apparatus is known which contains a target having an outer side of the sputtered material, magnets placed on a base on the inner side from the target and heat-insulated with a gap therefrom, a pipeline for a cooling medium having a wall with a part free of direct heat transfer from the target. Moreover, each magnet is mounted with the possibility of changing the distance from a part of the pipeline wall, and between each magnet and a corresponding part of the pipeline wall, an intermediate heat-transfer element made of non-ferromagnetic material with a high heat conductivity is installed, and the target is coupled with the base made of ferromagnetic material.

However, the magnets of these sputtering apparatuses are not protected from the thermal radiation of the heated target and from the impact of thermal energy from the heated chamber fitments on the peripheral magnets. Overheating of permanent magnets as a result of the impact of thermal radiation from the target and the chamber fitments leads to loss of magnetic properties and, as a consequence, to failure of the magnetron sputtering apparatus.

The design of these magnetrons has one function: the sputtering of target material. Functions of uniform gas distribution and protection of the workpiece surface from undesirable material deposition during the cleaning and heating of the magnetron target are provided by additional devices, for example by gas distribution systems and shutters, correspondingly, which complicate the design of vacuum chambers. On such additional devices, sputtering products accumulate and flake out, leading to an increase in defects of the applied coatings.

In the cathode assembly of the magnetron sputtering apparatus, the ferromagnetic base is flat and the magnets are mounted directly on the base. This does not make it possible to obtain a magnetic field with a "bottle configuration" of the necessary strength for the existence of DSSD. Due to the flat shape of the base and, consequently, of the target it is difficult to apply coatings with a required thickness uniformity on curvilinear surfaces.

From RU 111 138 U1, a magnetron sputtering cathode assembly is known consisting of a body in the form of a rectangular cuboid with a base, an extended flat target containing a sputtered material and fixed opposite the base of the body, as well as a magnetic system and a cooling system in the form of coaxial toroids located between the base of the body and a flat target in the centre of the body, in which the central region of the flat target is perforated with slits along its extended side. Besides, an additional gas distribution system is installed, and the base of the body is equipped with a branch pipe to supply plasma-forming gases. In this device, the magnetic system is made in the form of a matrix of permanent plate-like magnets, which are homogeneous in properties and displaced relative to each other in each row.

However, these magnetron sputtering apparatuses also have low reliability due to the possibility of simultaneous heating of the external parts of the magnetic system (the side part and the part facing the target) due to thermal radiation from the target and from the side walls of the magnetron body, which may lead to heating of the magnets to the Curie temperature at which they lose their magnetic properties.

The design of these magnetrons has two functions: sputtering of the target material and uniform supply of the plasma-forming gas through the gas distribution slits located in the centre of the target.

Due to the flat shape of the base and, consequently, of the target it is difficult to apply coatings with a required thickness uniformity on curvilinear surfaces.

Neither the patent RU 2319788 C2, nor the utility model RU 111138 U1 demonstrate that these magnetrons can work as unbalanced magnetrons (UBM) with double site sustained discharge (DSSD).

To clean and preheat the targets at the initial moment of use, an additional device is required, which is a moving shutter that completely shields the flow of the sputtered material, protecting the substrates from contamination. This shutter, located between the substrates and the UBM, is the source of the coating defects introduced due to deposition of coating on it, dust exfoliation and deposition of dust particles onto the substrates.

The object of the present invention is to provide a multifunctional cathode assembly for an unbalanced magnetron sputtering apparatus, the design of which allows for operation in the DSSD mode to clean the surface of workpieces as well as to deposit coating on them under conditions of high temperature load, to supplement the cathode assembly with the functions of the gas distribution device and the shutter for preheating and cleaning the target, as well as to improve coating thickness uniformity applied to workpieces of curvilinear shape.

### SUMMARY OF THE INVENTION

The present invention provides a multifunctional magnetron sputtering cathode assembly according to claim 1, in particular for an unbalanced magnetron sputtering apparatus. Preferred embodiments are given in the dependent claims.

The multifunctionality is preferably achieved by one or more of the following:
- To ensure the possibility of using UBM for final cleaning and heating of parts before coating, due to the special configuration of the magnetic field formed by peripheral permanent magnets, between the ferromagnetic base and these magnets a ferromagnetic support is placed with a height of at least 12 mm;
- to prevent demagnetization of permanent magnets and device failure due to simultaneous heating of the outer part of the magnetic system by thermal radiation from the target and from the side walls of the UBM body, the multifunctional assembly of the unbalanced magnetron sputtering apparatus is equipped with a liquid-cooled casing protecting the magnetic system from thermal radiation from the chamber fitments through the side walls of the body, and between the cooler, made in the form of a of rectangular tube, and the base, a Z-shaped shield is located, protecting the magnetic system from overheating by thermal radiation from the target;
- to ensure a possibility of the target cleaning and preheating without contamination of parts, the UBM is equipped with a coaxial vacuum-sealed rotary feedthrough for cooling, power supply a plasma-forming gas supply. The feedthrough is at the chamber potential and designed to turn the magnetron sputtering source to a direction opposite to the coated parts during cleaning and preheating of the cathode target;
- in order to apply optical coatings on the parts of complex shape with high thickness uniformity, the magnetic and cooling systems are made in the form of deformed coaxial toroids, and the base of the body as well as the target of the UBM are made in the shape close to the curvilinear surface of the optical part.

The placement of a peripheral magnetic system mounted to the base on ferromagnetic supports allows to obtain a magnetic field with a "bottle configuration" above the target surface with the parameters necessary for the existence of the DSSD. Such configuration of magnetic field enables the UBM to operate in a mode of cleaning and heating of the surface of the parts, as well as provides an ionic impact during the coating stage.

The heat-conducting shield connected to the cooler protects the magnetic system from thermal radiation heating from the the rear surface of the target, and the casing with cooled walls protects from thermal radiation heating from the vacuum chamber fitments. These parts protect the magnetic system from heating to the Curie temperature, at which the permanent magnets lose their properties, that results in the failure of the cathode-sputtering assembly.

The coaxial feedthrough for cooling, power supply and gas supply with a vacuum-sealed rotary unit allows, during the target preheating and cleaning before sputtering, to rotate the UBM in the direction opposite to the coated parts, for example towards the chamber wall and, thus, to prevent contamination of the workpieces surface during that stage.

The present invention also provides a magnetron sputtering apparatus, as defined in claim 6, comprising the inventive cathode-sputtering magnetron assembly.

The invention further relates to the use of the inventive magnetron sputtering apparatus, as defined in claim 7, for cleaning, heating or etching the surfaces of products, or for the application of coatings.

### BRIEF DESCRIPTION OF THE DRAWINGS

The invention is explained in more detail by the following description with reference to the drawings, wherein
- FIG. 1: shows a cross-section of an exemplary embodiment of an inventive magnetron sputtering cathode assembly;
- FIG. 2: shows a magnetron sputtering cathode assembly mounted in a vacuum chamber;
- FIG. 3: shows a linear magnetron sputtering cathode assembly to coat flat workpieces of large size moving towards the cathode;

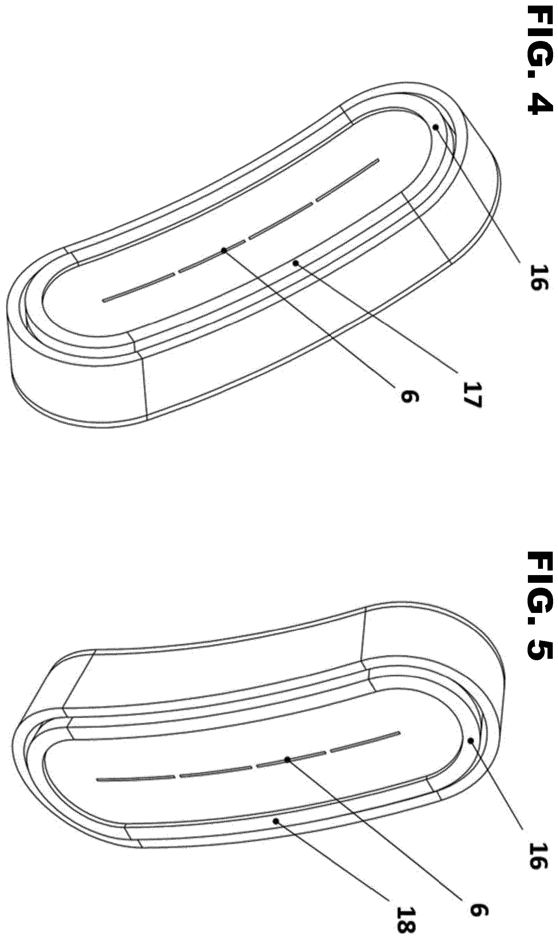

- FIG. 4: shows a magnetron sputtering cathode assembly to coat an outer surface of curved workpieces (for example, in the form of a pipe or a sphere); and
- FIG. 5: shows a magnetron sputtering cathode assembly to coat an inner surface of curved workpieces (for example, in the form of a pipe or a sphere);

### DETAILED DESCRIPTION OF THE INVENTION

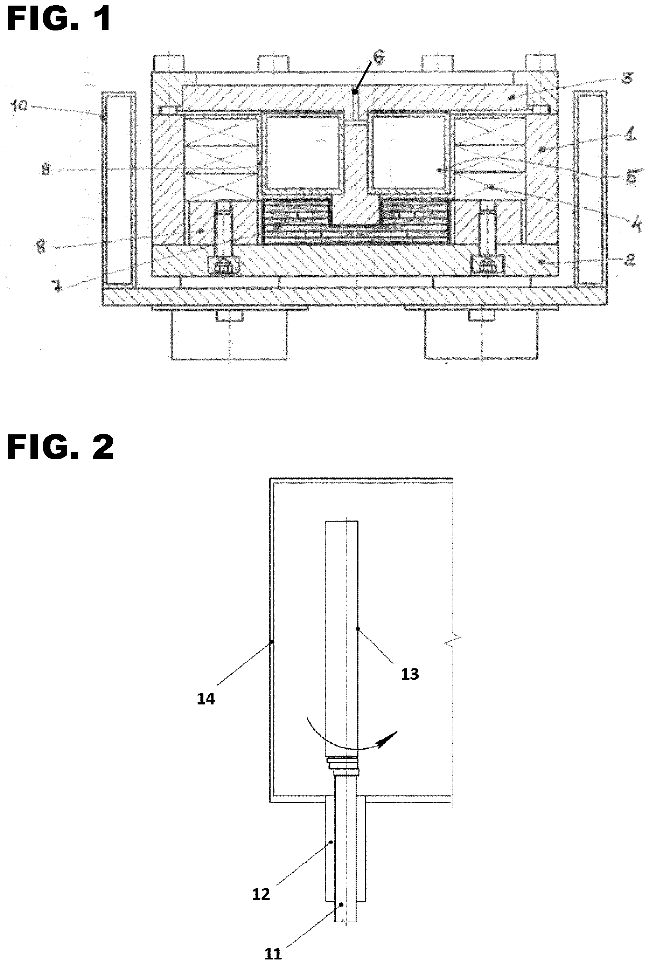

The magnetron sputtering cathode assembly shown in FIG. 1 consists of a body in the form of a rectangular cuboid 1 with a base 2, an extended flat target 3 made of a sputtered material and fixed to the base 2, a magnetic system 4 and a cooler 5 in the form of coaxial toroids, located between the base of the body and the flat target in the centre of the body, wherein the central region of the flat target is perforated with slits 6 along its extended side, and wherein at the centre of the body an additional gas distribution system 7 is installed. The magnetic system is made in the form of a matrix of permanent plate-like magnets, which are uniform in magnetic properties and displaced towards each other in each row.

To obtain the required configuration and strength of magnetic field above the target surface 3, the magnetic system is placed on a special support 8 with a height of at least 12 mm made of a ferromagnetic material.

The Z-shaped heat-conducting shield 9 is made, for example, of copper and placed above the magnets 4. It is in thermal contact with the cooler 5 in the form of a rectangular tube and allows to protect the magnetic system from thermal radiation heating by the rear surface of the target. The casing 10 with cooled walls protects the body from thermal radiation heating by the vacuum chamber fitments.

As shown in FIG. 2, coaxial rotary feedthrough 11 for cooling, power supply and gas supply with a vacuum-sealed unit 12 allows for the target preheating and cleaning before the coating application to rotate the target surface of the unbalanced magnetron (UBM) apparatus 13 in the direction opposite to the coated workpieces, for example towards the chamber wall 14 in order to prevent contamination of the surface of the parts during that stage.

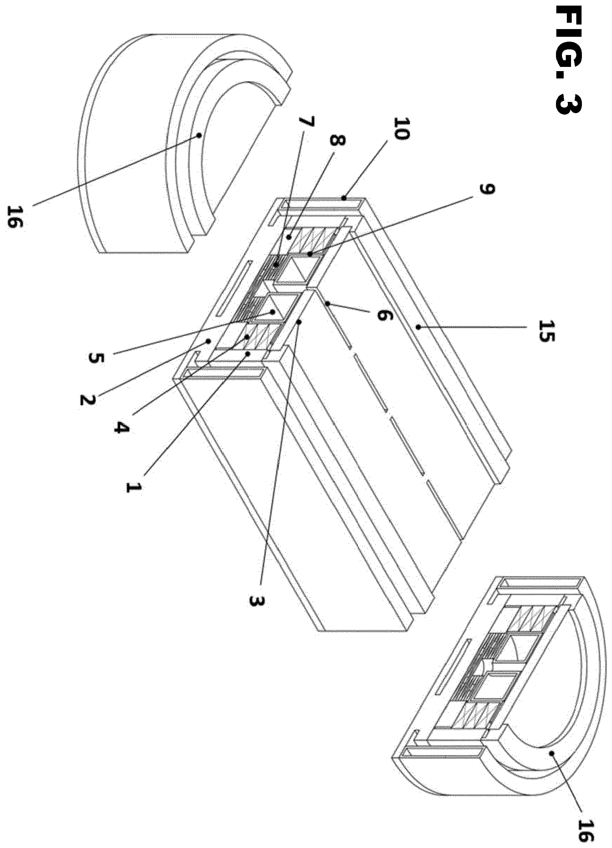

In order to coat flat workpieces of large size moving towards the cathode, the UBM is made in the form of a toroid compressed in the plane and consisting of a straight section 15 and curved sections 16, as shown in FIG. 3. The cathode's target has slits 6 for uniform supply of a working gas along the cathode through the gas distribution system 7.

In order to coat an outer surface of curved workpieces (for example, in the form of a pipe or a sphere) the middle section 17 of the cathode is made concave and complemented by the curved sections 16.

In order to coat an inner surface of curved workpieces (for example, in the form of a pipe or a sphere) the middle section 18 of the cathode is made convex and complemented by the curved sections 16.

The inventive magnetron sputtering cathode assembly operates as follows.

The device is placed in a vacuum chamber 14 from which air is evacuated, and then a plasma-forming gas is supplied through the coaxial feedthrough 11, the gas distribution system 7 and slits 6 in the target to the chamber. A coolant is supplied through the coaxial feedthrough cooling lines. The cathode assembly 13 is connected to the negative pole of the power supply, and the anode system (not shown) to the positive one. A gas-discharge plasma zone is created above the target, which is supported by crossed electric and magnetic fields. The electrons of the plasma formed above the target surface are confined by the magnetic field and move along a closed trajectory over the target surface, ionizing the plasma-forming gas. The resulting positive ions of the plasma-forming gas are accelerated by the electric field of the cathode assembly, gain kinetic energy and bombard the target so that the target material (titanium, aluminium, silicon, zirconium or other material) particles are knocked out from the target and condensed on the surface of the coated parts (not shown in the drawing).

Due to the presence of the support 8, the magnetic system made of peripheral magnets with the required parameters forms an additional magnetic field in the form of a "bottle" with a strength of more than 100 Oe, which is sufficient to capture electrons with energy exceeding the ionization energy of the plasma-forming gas and the sputtered material. This provides the conditions for the DSSD existence and a possibility of both cleaning and preheating of the workpiece surface, as well as for ionic impact during coating stage, when a bias voltage is applied to the workpiece.

The coolant circulating through the pipeline 5 provides cooling of the target 3, preventing its destruction by thermal loads, as well as cooling of the shield 9 of the magnets 4, protecting the magnets from thermal radiation from the target. The coolant circulating through the duct of the casing 10 prevents heating of the magnetron body walls from the thermal radiation of the vacuum chamber fitments and overheating of the outer side of the magnets.

In the course of preheating and cleaning of the target prior coating application, using the coaxial rotary feedthrough 11 with a vacuum-sealed unit 12, the front side of the UBM apparatus 13 is rotated in the direction opposite to the coated parts, for example, towards a chamber wall 14, thus preventing contamination of the surface of the parts during this stage. Upon completion of the target cleaning and preheating, the UBM is rotated back towards the parts without loss of sealing. Thereafter, the coating can be applied. The invention is defined by the claims.

## Claims

1. A magnetron sputtering cathode assembly consisting of a body, which has the form of a rectangular cuboid (1) and comprises a base (2), of an extended flat target (3) containing a material to be sputtered and fixed to the base (2) of the body, as well as of a magnetic system (4) and of a cooler (5) in the form of coaxial toroids located between the base (2) of the body and the flat target (3) in the centre of the body,
wherein the central region of the flat target (3) is perforated with holes or slits (6) along its extended side, and
wherein the magnetron sputtering cathode assembly also comprises an additional gas distribution system (7) installed at the centre of the body, **characterized in that** the magnetic system is mounted to the base (2) on ferromagnetic supports (8), and **in that** the magnetron sputtering cathode assembly further comprises a Z-shaped heat-conducting shield (9) installed between the inner surface of the target (3) and the magnetic system (4), the Z-shaped heat-conducting shield (9) being connected to the cooler (5) made in the form of a of rectangular tube, and a casing (10) having cooled walls,
wherein the base (2) is provided with a coaxial rotary feedthrough (11) having a vacuum-sealed unit (12) for cooling, power supply and gas supply lines.

2. The magnetron sputtering cathode assembly according to claim 1, wherein the ferromagnetic supports (8) have a height of at least 12 mm.

3. The magnetron sputtering cathode assembly according to claim 1 or 2, wherein the magnetic system (4) is located in a cavity.

4. The magnetron sputtering cathode assembly according to any one of claims 1 to 3, wherein the magnetic system (4) and the cooler (5) are made in the form of symmetrical deformed toroids which are concave in their middle sections (17), and wherein the shape of the target (3) replicates the shape of the cooler (5).

5. The magnetron sputtering cathode assembly according to any one of claims 1 to 3, wherein the magnetic system (4) and the cooler (5) are made in the form of symmetrical deformed toroids which are convex in their middle sections (18), and wherein the shape of the target (3) replicates the shape of the cooler (5).

6. An unbalanced magnetron sputtering apparatus (13), comprising the magnetron sputtering cathode assembly according to any one of claims 1 to 5.

7. Use of the unbalanced magnetron sputtering apparatus according to claim 6 for cleaning, heating or etching the surfaces of products, or for the application of coatings.

## Patentansprüche

1. Kathodenanordnung zum Magnetronsputtern, bestehend aus einem Körper, der die Form eines rechtwinkligen Quaders (1) aufweist und eine Basis (2) umfasst, aus einem verlängerten flachen Target (3), welches das zu sputternde Material enthält und an der Basis (2) des Körpers fixiert ist, sowie aus einem magnetischen System (4) und einem Kühler (5) in Form von koaxialen Toroiden, die zwischen der Basis (2) des Körpers und dem flachen Target (3) im Zentrum des Körpers angeordnet sind,
wobei der zentrale Bereich des flachen Targets (3) entlang seiner verlängerten Seite mit Löchern oder Schlitzen (6) perforiert ist, und
wobei die Kathodenanordnung zum Magnetronsputtern ferner ein zusätzliches Gasverteilungssystem (7) umfasst, welches im Zentrum des Körpers installiert ist,
**dadurch gekennzeichnet, dass** das magnetische System auf ferromagnetischen Trägern (8) an der Basis (2) montiert ist, und
dass die Kathodenanordnung zum Magnetronsputtern ferner einen Z-förmigen wärmeleitenden Schild (9) umfasst, der zwischen der inneren Oberfläche des Targets (3) und dem magnetischen System (4) installiert ist, wobei der Z-förmige wärmeleitende Schild (9) mit dem in Form eines rechtwinkligen Kanals ausgebildeten Kühler (5) verbunden ist, und ein Gehäuse (10) mit gekühlten Wänden,
wobei die Basis (2) mit einer koaxialen radialen Durchführung (11) versehen ist, die eine vakuumdichte Einheit (12) für Kühlung, Energieversorgung und Gasversorgungsleitungen aufweist.

2. Kathodenanordnung zum Magnetronsputtern nach Anspruch 1, wobei die ferromagnetischen Träger (8) eine Höhe von mindestens 12 mm aufweisen.

3. Kathodenanordnung zum Magnetronsputtern nach Anspruch 1 oder 2, wobei das magnetische System (4) in einem Hohlraum angeordnet ist.

4. Kathodenanordnung zum Magnetronsputtern nach einem der Ansprüche 1 bis 3, wobei das magnetische System (4) und der Kühler (5) in Form von symmetrisch deformierten Toroiden ausgeführt sind, die in ihren Mittelteilen (17) konkav sind, und wobei die Form des Targets (3) die Form des Kühlers (5) repliziert.

5. Kathodenanordnung zum Magnetronsputtern nach einem der Ansprüche 1 bis 3, wobei das magnetische System (4) und der Kühler (5) in Form von symmetrisch deformierten Toroiden ausgeführt sind, die in ihren Mittelteilen (18) konvex sind, und wobei die Form des Targets (3) die Form des Kühlers (5) repliziert.

6. Vorrichtung (13) zum unbalanzierten Magnetronsputtern, umfassend die Kathodenanordnung zum Magnetronsputtern nach einem der Ansprüche 1 bis 5.

7. Verwendung der Vorrichtung zum unbalanzierten Magnetronsputtern nach Anspruch 6 zum Reinigen, Erhitzen oder Ätzen der Oberflächen von Produkten, oder für das Aufbringen von Beschichtungen.

## Revendications

1. Ensemble cathodique de pulvérisation par magnétron se composant d'un corps qui a la forme d'un cuboïde rectangulaire (1) et comprend une base (2), d'une cible plate étendue (3) contenant un matériau à pulvériser et fixé à la base (2) du corps, ainsi que d'un système magnétique (4) et d'un refroidisseur (5) se présentant sous la forme de toroïdes coaxiaux positionnés entre la base (2) du corps et la cible plate (3) dans le centre du corps,
dans lequel la région centrale de la cible plate (3) est perforée avec des trous ou des fentes (6) le long de son côté étendu, et
dans lequel l'ensemble cathodique de pulvérisation par magnétron comprend également un système de distribution de gaz additionnel (7) installé au niveau du centre du corps,
**caractérisé en ce que** le système magnétique est monté sur la base (2) sur des supports ferromagnétiques (8), et
**en ce que** l'ensemble cathodique de pulvérisation par magnétron comprend en outre un bouclier thermo-conducteur en forme de Z (9) installé entre la surface interne de la cible (3) et le système magnétique (4), le bouclier thermo-conducteur en forme de Z (9) étant raccordé au refroidisseur (5) réalisé sous la forme d'un tube rectangulaire, et
un carter (10) ayant des parois refroidies,
dans lequel la base (2) est prévue avec une connexion d'interface rotative coaxiale (11) ayant une unité scellée sous vide (12) pour le refroidissement, des conduites d'alimentation en énergie et d'alimentation en gaz.

2. Ensemble cathodique de pulvérisation par magnétron selon la revendication 1, dans lequel les supports ferromagnétiques (8) ont une hauteur d'au moins 12 mm.

3. Ensemble cathodique de pulvérisation par magnétron selon la revendication 1 ou 2, dans lequel le système magnétique (4) est positionné dans une cavité.

4. Ensemble cathodique de pulvérisation par magnétron selon l'une quelconque des revendications 1 à 3, dans lequel le mécanisme magnétique (4) et le refroidisseur (5) sont réalisés sous la forme de toroïdes symétriques déformés qui sont concaves dans leurs sections centrales (17), et dans lequel la forme de la cible (3) reproduit la forme du refroidisseur (5).

5. Ensemble cathodique de pulvérisation par magnétron selon l'une quelconque des revendications 1 à 3, dans lequel le système magnétique (4) et le refroidisseur (5) sont réalisés sous la forme de toroïdes symétriques déformés qui sont convexes dans leurs sections centrales (18), et dans lequel la forme de la cible (3) reproduit la forme du refroidisseur (5).

6. Appareil de pulvérisation par magnétron déséquilibré (13) comprenant l'ensemble cathodique de pulvérisation par magnétron selon l'une quelconque des revendications 1 à 5.

7. Utilisation de l'appareil de pulvérisation par magnétron déséquilibré selon la revendication 6, pour nettoyer, chauffer ou graver les surfaces de produits ou pour l'application de revêtements.
